(19) Europäisches Patentamt
European Patent Office
Office européen des brevets

(11) **EP 4 435 397 B1**

(12) **EUROPEAN PATENT SPECIFICATION**

(45) Date of publication and mention
of the grant of the patent:
**10.12.2025 Bulletin 2025/50**

(51) International Patent Classification (IPC):
**G01K 7/42** *(2006.01)*     **G01K 17/20** *(2006.01)*
**G05B 13/02** *(2006.01)*

(21) Application number: **23162860.3**

(22) Date of filing: **20.03.2023**

(52) Cooperative Patent Classification (CPC):
**G01K 7/427; G01K 17/20; G05B 13/027;**
G06F 30/367

(54) **A METHOD FOR ESTIMATING A PHYSICAL QUANTITY OF A STATIC ELECTRIC INDUCTION DEVICE ASSEMBLY**

VERFAHREN ZUR SCHÄTZUNG EINER PHYSIKALISCHEN GRÖSSE EINER STATISCHEN ELEKTRISCHEN INDUKTIONSVORRICHTUNGSANORDNUNG

PROCÉDÉ D'ESTIMATION D'UNE QUANTITÉ PHYSIQUE D'UN ENSEMBLE DE DISPOSITIF À INDUCTION ÉLECTRIQUE STATIQUE

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**

(43) Date of publication of application:
**25.09.2024 Bulletin 2024/39**

(73) Proprietor: **Hitachi Energy Ltd**
**8050 Zürich (CH)**

(72) Inventors:
• **LANERYD, Tor**
**745 38 Enköping (SE)**
• **LUVISOTTO, Michele**
**723 34, Västerås (SE)**
• **CHAKRAVORTY, Jhelum**
**H3G1Y2 Montreal, Québec (CA)**
• **ABAURREA-VELASCO, Clara**
**8953 Dietikon (CH)**

(74) Representative: **Valea AB**
**Box 1098**
**405 23 Göteborg (SE)**

(56) References cited:
**CN-A- 102 427 218**     **CN-A- 105 550 472**
**US-A1- 2016 005 522**

## Description

TECHNICAL FIELD

The present invention relates to a method for estimating a physical quantity of a static electric induction device assembly. Moreover, the present invention relates to each one of a computer program product, a non-transitory computer-readable storage medium and a control unit.

BACKGROUND OF THE INVENTION

In a static electric induction device assembly, such as for example an assembly comprising a transformer or a shunt reactor, it may be desired to obtain information indicative of a physical quantity thereof. Purely by way of example, it may be desired to determine information relating to heat losses associated with at least a portion of the static electric induction device assembly.

However, it may be a challenging task to obtain such information from e.g. a numerical model of the static electric induction device assembly. Moreover, since a static electric induction device may comprise a static electric induction device surrounded by liquid in an enclosure, such as a tank, it may also be a challenging task to determine the above information by means of experiments. US 2016/0005522 A1 discloses the prediction of oil temperature of a transformer for a desired load. A machine learning algorithm is developed using historical data of the transformer.

SUMMARY OF THE INVENTION

In view of the above, an object of the present invention is to provide a method for estimating a physical quantity of a static electric induction device assembly, which method provides appropriately reliable results.

The above object is achieved by a method according to claim 1.

As such, the present invention relates to a method for estimating a physical quantity of a static electric induction device assembly. The static electric induction device assembly comprises an enclosure, a static electric induction device and a liquid whereby the enclosure accommodates the static electric induction device and the liquid such that the static electric induction device is at least partially, preferably fully, submerged into the liquid. The method comprises using measured temperature data obtained from a measurement assembly. The measured temperature data comprises a temperature in each one of a plurality of different locations of the static electric induction device assembly as a function of time for a reference time range when the static electric induction device assembly is in a condition in which at least a portion of the static electric induction device generates heat during at least a portion of the reference time range.

The method further comprises:

- using a time dependent partial differential equation representing a physical condition of the static electric induction device assembly during the reference time range, wherein the physical quantity forms a source term of the partial differential equation;
- generating a temperature model for estimated temperature data, the estimated temperature data corresponding to an estimated temperature in each one of the plurality of different locations of the static electric induction device assembly as a function of time, the temperature model comprising a first neural network representing the estimated temperature data as well as the measured temperature data, and
- estimating the physical quantity by training a neural network system that uses at least the following entities: the time dependent partial differential equation, information from the temperature model and a second neural network for the physical quantity.

The method according to the above implies an appropriate accuracy in the estimation of the physical quantity since the method uses information from the temperature model for estimating the physical quantity of interest.

As used herein, the term expression "source term" of the partial differential equation is intended to encompass a term relating to a net inflow or a net outflow of a physical entity in a portion of the static electric induction device assembly.

As an example, a steady state temperature distribution of a body may generally be established by solving the Laplace equation $\Delta T = 0$ with appropriate boundary conditions. However, if there is a net inflow or a net outflow of a physical entity in a portion of the body which can be represented by a function J, the Laplace equation may be reformulated in accordance with the following: $\Delta T = J$. As such, the function J is a source term in the thus reformulated Laplace equation.

It should be noted that the function J, depending on the partial differential equation and the characteristics of the net inflow or net outflow, may be dependent on one more of a plurality of parameters, such as at least one of the following parameters: time t, location x and temperature T. Thus, the source term may for example be formulated in accordance with the following: $J = J(t, x, T)$.

Purely by way of example, the time dependent partial differential equation may be a heat equation that has a temperature T as an unknown variable. This example can apply to every embodiment of the present invention.

Optionally, the method further comprises establishing a set of partial differential equation entities associated with a probability distribution on the solution to the time dependent partial differential equation. The method further comprising generating a partial differential equation cost function that includes the partial differential equation entities, wherein training the neural network system comprises:

- determining the set of partial differential equation entities such that a corresponding value of the partial differential equation cost function is within a predetermined range and/or
- varying the set of partial differential equation entities until a predetermined stop condition has been obtained.

The above features imply that training the neural network system may comprise an iterative procedure that carries out a number of iterations. This in turn implies an appropriately large possibility to obtain reasonably accurate results.

Optionally, the partial differential equation cost function comprises at least one of the following:

- a set of residual entities and a residual associated with the time dependent partial differential equation, preferably the residual entities comprising, alternatively being constituted by, residual functionals;
- a set of boundary condition entities and at least one boundary condition associated with the time dependent partial differential equation, preferably the boundary condition entities comprising, alternatively being constituted by, boundary condition functionals, and
- a set of initial condition entities and at least one initial condition associated with the time dependent partial differential equation, preferably the initial condition entities comprising, alternatively being constituted by, initial condition functionals.

As used herein, the term "functional" is intended to encompass a mapping from a space into a field of real or complex numbers. The space may comprise functions whereby a functional may be referred to as a function that uses another function as input. As a non-limiting example, an integral may be an example of a functional since the integral uses a function as an input and the result from the integral may be a real or complex number, depending e.g. on the characteristic of the function input into the integral.

Optionally, the residual associated with the time dependent partial differential equation is determined using at least information from the temperature model, preferably using the estimated temperature in each one of the plurality of different locations of the static electric induction device assembly as a function of time. As such, information from the temperature model, for instance the estimated temperature, may be used for determining the above-mentioned set of residual entities. This in turn implies that the measured temperature data, being represented by the temperature model, may be used when determining the above-mentioned residual. However, the measured temperature data *per* se need to be used for determining the residual. Instead, the measured temperature data may be represented by the first neural network which in turn forms part of the temperature model. This implies an appropriately high level of accuracy for the residual, since the temperature model may be associated with a level of accuracy exceeding the accuracy of the measured temperature data as such. For instance, the temperature model may provide temperature information in locations and/or instances in which the temperature is not measured.

Optionally, the set of partial differential equation entities comprises a set of temperature entities associated with a probability distribution on the solution to the temperature model, wherein the partial differential equation cost function comprises an addend including the temperature entities and a temperature cost function including the estimated temperature data and the measured temperature data. Preferably, the temperature entities comprise, alternatively are constituted by, temperature hyperparameters.

Optionally, the method comprises training the first neural network using the measured temperature data to thereby obtain the temperature model, wherein the temperature model is thereafter used for training the neural network system.

As have been intimated above, training the neural network system using the temperature model rather than the measured temperature data only implies an appropriately high accuracy of the method.

Optionally, the step of obtaining the temperature model comprises establishing a set of temperature entities associated with a probability distribution on the solution to the temperature model. Preferably the temperature entities comprise, alternatively are constituted by, temperature hyperparameters, wherein training the first neural network comprises generating a temperature cost function that includes a set of temperature entities, the estimated temperature data and the measured temperature data and

- determining the set of temperature entities such that a corresponding value of the temperature cost function is within a predetermined temperature range and/or

- varying the set of temperature entities until a predetermined stop condition has been obtained.

As such, the temperature entities, such as the temperature hyperparameters, may for instance be determined using an iterative procedure that carries out a number of iterations. This in turn implies an appropriately large possibility to obtain reasonably accurate results.

Optionally, the physical quantity represents at least one of the following of the static electric induction device assembly: heat losses through the enclosure, stray losses in metallic parts of the static electric induction device and hotspot temperatures associated with the static electric induction device.

Optionally, the static electric induction device comprises a transformer and/or a shunt reactor.

Optionally, the neural network system further uses a temperature dependent material property, such as heat conductivity, of at least a portion of the enclosure.

A second aspect of the present invention relates to a method for evaluating a static electric induction device assembly. The static electric induction device assembly comprises a static electric induction device located in the interior of an enclosure. The assembly further comprising a liquid located in the interior of an enclosure, which liquid surrounds the static electric induction device. The method comprises:

- arranging the static electric induction device assembly in a condition in which at least a portion of the static electric induction device generates heat;
- determining measured temperature data using a measurement assembly, the measured temperature data comprising a temperature in each one of a plurality of different locations of the static electric induction device assembly as a function of time for a reference time range when the static electric induction device assembly is the condition in which at least a portion of the static electric induction device generates heat during at least a portion of the reference time range, and
- estimating a physical quantity of a static electric induction device assembly using a method according the first aspect of the present invention.

Optionally, the enclosure has an exterior surface facing away from interior of the enclosure, wherein the measurement assembly comprises one or more sensing devices adapted to sense the temperature on a plurality of different locations on the exterior surface of the enclosure.

Optionally, the measurement assembly comprises one or more thermal cameras and wherein the step of determining measured temperature data comprises capturing images of the exterior surface using the one or more thermal cameras.

Optionally, the step of determining the measured temperature data comprises transforming images captured by the one or more thermal cameras onto the exterior surface.

A third aspect of the present invention relates to a computer program product comprising program code for performing, when executed by a processor device, the method of the first aspect of the present invention.

A fourth aspect of the present invention relates to a non-transitory computer-readable storage medium comprising instructions, which when executed by a processor device, cause the processor device to perform the method of the first aspect of the present invention.

A fifth aspect of the present invention relates to a control unit arranged to perform the method of the first aspect of the present invention.

BRIEF DESCRIPTION OF THE DRAWINGS

With reference to the appended drawings, below follows a more detailed description of embodiments of the disclosure cited as examples.

In the drawings:

Fig. 1    is a schematic illustration of a static electric induction device assembly;

Fig. 2    is a schematic illustration of a method embodiment of the present invention, and

Fig. 3    is a schematic illustration of another method embodiment of the present invention.

DETAILED DESCRIPTION OF PREFERRED EMBODIMENTS

Preferred embodiments of the present disclosure will be discussed hereinbelow with reference to the appended drawings.

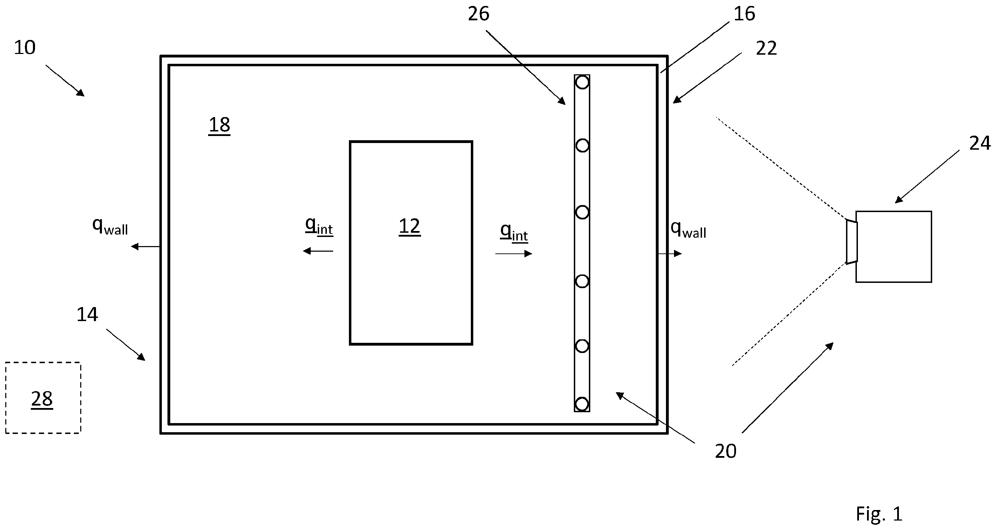

Figs. 1 schematically illustrates an embodiment of a static electric induction device assembly 10. The static electric induction device assembly comprises an enclosure 14, a static electric induction device 12 and a liquid 18 whereby the enclosure 14 accommodates the static electric induction device 12 and the liquid 18 such that the static electric induction device 12 is at least partially, preferably fully, submerged into the liquid 18. In the Fig. 1 embodiment, the static electric induction device 12 is fully submerged into the liquid 18. As a non-limiting example, the static electric induction device 12 may comprise, or even be constituted by, a transformer and/or a shunt reactor. Moreover, as indicated in Fig. 1, the enclosure 14 may be delimited by an enclosure wall 16.

Purely by way of example, the enclosure wall 16 may comprise, or even be constituted by, a metallic material such as steel.

Moreover, as a non-limiting example, the enclosure 14 may be referred to as a tank.

Further, purely by way of example, the liquid 18 may comprise or even be constituted by a dielectric liquid, such as a mineral oil.

The static electric induction device assembly 10 may be adapted to assume a condition in which at least a portion of the static electric induction device 12 generates heat. Purely by way of example, and as indicated in Fig. 1, when the static electric induction device 12 is operated, it may generate interior heat losses $q_{int}$. As non-limiting examples, if the static electric induction device 12 comprises, or even is constituted by, a transformer and/or a shunt reactor, the interior heat losses $q_{int}$ may be caused by a core (not shown) and windings (not shown) of the static electric induction device 12. Such interior heat losses $q_{int}$ may propagate via the liquid 18 towards the enclosure wall 16.

Moreover, heat may propagate through the enclosure wall 16 resulting in enclosure wall heat losses $q_{wall}$. Purely by way of example, the magnitude of the enclosure wall heat losses $q_{wall}$ may be dependent on the temperature difference over the enclosure wall 16, viz the difference between the temperature of the liquid 18 on the inside of the enclosure wall and the temperature of the fluid, such as air, ambient of the enclosure wall 16, as well as an enclosure heat transfer parameter, such as a wall diffusion coefficient $k_{wall}$ indicative of a diffusion over the enclosure wall 16.

The method of the present invention comprises using measured temperature data obtained from a measurement assembly 20. The measured temperature data comprises a temperature $T_{true}(\mathbf{x}, t)$ in each one of a plurality of different locations of the static electric induction device assembly 10 as a function of time t for a reference time range $\Delta T_{ref}$ when the static electric induction device assembly 10 is in a condition in which at least a portion of the static electric induction device 12 generates heat during at least a portion of the reference time range $\Delta T_{ref}$. For the sake of completeness, it should be noted that a location is herein generally denoted by an x in order to elucidate that the location may be expressed in terms of one, two or three dimensions, for instance depending on the characteristics of the measured temperature data.

As indicated in Fig. 1, the measurement assembly 20 may comprise one or more measurement entities.

In the Fig. 1 embodiment, the enclosure 14 has an exterior surface 22 facing away from the interior of the enclosure 14. Purely by way of example, and as indicated in Fig. 1, the exterior surface 22 may be the outer surface of the enclosure wall 16. Moreover, the measurement assembly 20 may comprise one or more sensing devices adapted to sense the temperature on a plurality of different locations on the exterior surface 22 of the enclosure 14.

Purely by way of example, the measurement assembly 20 may comprise one or more thermal cameras 24 (only one camera is indicated in Fig. 1) and the step of determining measured temperature data may comprise capturing images of the exterior surface using the one or more thermal cameras.

However, implementations of the measurement assembly 20 may comprise other types of sensors. To this end, reference is again made to Fig. 1 in which an array 26 of temperature sensors is located within the interior of the enclosure 14 wherein each temperature sensor in the array 26 for instance may measure a temperature of the liquid 18 located in the interior of the enclosure 14.

For the sake of completeness, it should be noted that implementations of the measurement assembly 20 may comprise a plurality of different sensors of different types.

Irrespectively of how the temperature $T_{true}(\mathbf{x}, t)$ in each one of the plurality of different locations of the static electric induction device assembly 10 as a function of time t for the reference time range $\Delta T_{ref}$ has been determined, the method of the present invention comprises:

- using a time dependent partial differential equation representing a physical condition of the static electric induction device assembly during the reference time **range** $\Delta T_{ref}$, wherein the physical quantity forms a source term of the partial differential equation;
- generating a temperature model for estimated temperature data $T_{est}(\mathbf{x}, t)$, the estimated temperature data $T_{est}(\mathbf{x}, t)$ corresponds to an estimated temperature in each one of the plurality of different locations of the static electric induction device assembly 10 as a function of time t, the temperature model comprising a first neural network NN1 representing the estimated temperature data $T_{est}(\mathbf{x}, t)$ as well as the measured temperature data $T_{true}(\mathbf{x}, t)$, and
- estimating the physical quantity by training a neural network system that uses at least the following entities: the time dependent partial differential equation, information from the temperature model and a second neural network NN2 for the physical quantity.

As non-limiting examples, the physical quantity may represent at least one of the following of the static electric induction device assembly 10: heat losses through the enclosure 14, stray losses in metallic parts of the static electric induction device 12 and hotspot temperatures associated with the static electric induction device 12.

By way of example only, the neural network system may be referred to as a physics-informed neural network.

Moreover, Fig. 1 indicates a control unit 28. Purely by way of example, the control unit 28 may be arranged to perform the method of the first aspect of the present invention. To this end, though purely by way of example, the control unit 28 may be adapted to receive information from relevant entities, such as the measurement assembly 20 and the static electric induction device 12.

Purely by way of example, the method further comprises establishing a set of partial differential equation entities $ß_{PDE}$, $ß_{IC}$, $ß_{BC}$ associated with a probability distribution on the solution to the time dependent partial differential equation. The method further comprises generating a partial differential equation cost function $L_{total}$ that includes the partial differential equation entities $ß_{PDE}$, $ß_{IC}$, $ß_{BC}$, wherein training the neural network system comprises:

- determining the set of partial differential equation entities $ß_{PDE}$, $ß_{IC}$, $R_{BC}$ such that a corresponding value of the partial differential equation cost function $L_{total}$ is within a predetermined range and/or
- varying the set of partial differential equation entities until a predetermined stop condition has been obtained.

As a non-limiting example, the partial differential equation cost function may comprise at least one of the following:

- a set of residual entities $ß_{PDE}$ and a residual $e_{PDE}$ associated with the time dependent partial differential equation, preferably the residual entities comprising $ß_{PDE}$, alternatively being constituted by, residual functionals;
- a set of boundary condition entities $ß_{BC}$ and at least one boundary condition $L_{BC}$ associated with the time dependent partial differential equation, preferably the boundary condition entities comprising, alternatively being constituted by, boundary condition functionals, and
- a set of initial condition entities $ß_{IC}$ and at least one initial condition $L_{IC}$ associated with the time dependent partial differential equation, preferably the initial condition entities comprising, alternatively being constituted by, initial condition functionals.

As a non-limiting example, the residual $e_{PDE}$ associated with the time dependent partial differential equation may be determined using at least information from the temperature model, preferably using the estimated temperature $T_{est}(\mathbf{x}, t)$ in each one of the plurality of different locations x of the static electric induction device assembly 10 as a function of time t. As such, though by way of example only, the residual $e_{PDE}$ may be determined using at least portions of the estimated temperature data $T_{est}(\mathbf{x}, t)$.

Purely by way of example, the set of partial differential equation entities comprises a set of temperature entities $ß_T$ associated with a probability distribution on the solution to the temperature model, wherein the partial differential equation cost function comprises an addend $ß_T L_T$ including the temperature entities $ß_T$ and a temperature cost function $L_T$ including the estimated temperature data $T_{est}(\mathbf{x}, t)$ and the measured temperature data $T_{true}(\mathbf{x}, t)$. Preferably, the temperature entities $ß_T$ comprise, alternatively are constituted by, temperature hyperparameters.

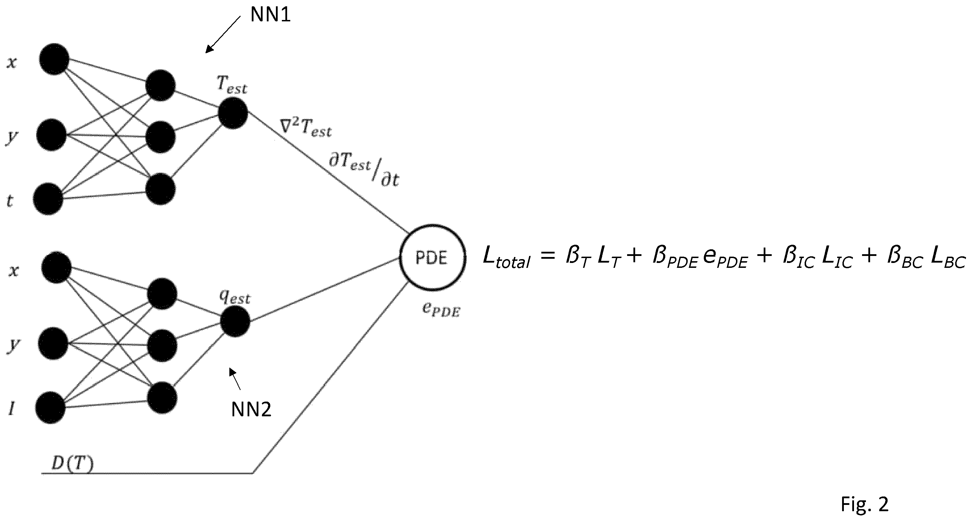

As such, in embodiments of the invention, the first neural network NN1 and the neural network system may be trained simultaneously. Such an embodiment is schematically illustrated in Fig. 2.

Optionally, the method may comprise training the first neural network NN1 using the measured temperature data $T_{true}(\mathbf{x}, t)$ to thereby obtain the temperature model, wherein the temperature model is thereafter used for training the neural network system.

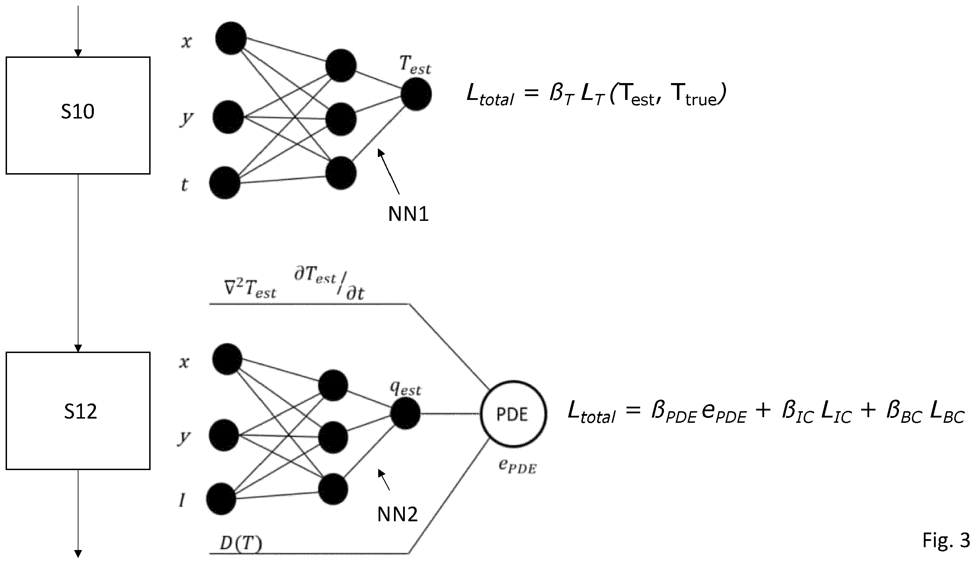

As such, as exemplified in Fig. 3, in embodiments of the invention, the first neural network NN1 may be trained in a first step S10 and the result from the first step S10 is thereafter used for training the neural network system, see step S12 in Fig. 3.

Moreover, as indicated in Fig. 3, the step S10 of obtaining the temperature model comprises establishing a set of temperature entities $ß_T$ associated with a probability distribution on the solution to the temperature model. Preferably, the temperature entities comprise, alternatively are constituted by, temperature hyperparameters, wherein training the first neural network NN1 comprises generating a temperature cost function $L_{Total}$ that includes the set of temperature entities $ß_T$, the estimated temperature data $T_{est}(\mathbf{x}, t)$ and the measured temperature data $T_{true}(\mathbf{x}, t)$ and

- determining the set of temperature entities $ß_T$ such that a corresponding value of the temperature cost function $L_{Total}$ is within a predetermined temperature range and/or

- varying the set of temperature entities $ß_T$ until a predetermined stop condition has been obtained.

As such, the temperature entities $ß_T$, such as the temperature hyperparameters $ß_T$, may for instance be determined using an iterative procedure that carries out a number of iterations. The temperature entities $\beta_T$ may thereafter be used in order to determine the estimated temperature data $T_{est}(\mathbf{x}, t)$.

It should be noted that the procedure of training the first neural network NN1 may be performed in a manner presented in US 10,963,540 B2. It should be noted that any one of the training procedures presented in US 10,963,540 B2 may be applied to each one of the embodiments presented hereinabove with reference to Fig. 2 and Fig. 3, respectively.

Optionally, the neural network system further uses the following: a temperature dependent material property $D(T)$, such as heat conductivity, of at least a portion of the enclosure 14. Such a possibility is indicated in each one of Fig. 2 and Fig. 3.

It should be noted that although the Fig. 2 embodiment trains the first neural network NN1 and the neural network system simultaneously and the Fig. 3 embodiment trains the first neural network NN1 before the neural network system simultaneously, other embodiments of the method of the present inventions are also contemplated.

Purely by way of example, it is contemplated that embodiments of the method of the invention may employ an iterative procedure in which the first neural network NN1 is only partly trained and that the temperature model obtained from such a partial training is thereafter used for training the neural network system. Thereafter, the first neural network NN1 may be trained further and the thus resulting temperature model may be used for further training the neural network system.

Purely by way of example, the first neural network NN1 may be trained only partly by choosing a first predetermined temperature range and determine e.g. temperature entities $ß_T$ such that a corresponding value of the temperature cost function $L_{Total}$ is within the first predetermined temperature range. Thereafter, in the further training of the first neural network NN1, a second predetermined temperature range that is narrower than the first predetermined temperature range, may be used that the temperature entities $ß_T$ may be determined such that a corresponding value of the temperature cost function $L_{Total}$ is within the second predetermined temperature range.

A second aspect of the present invention relates to a method for evaluating a static electric induction device assembly 10. The static electric induction device assembly 10 comprises a static electric induction device 12 located in the interior of an enclosure 14. The assembly 10 further comprises a liquid 18 located in the interior of the enclosure 14, which liquid 18 at least partly surrounds the static electric induction device 12. The method comprises:

- arranging the static electric induction device assembly 10 in a condition in which at least a portion of the static electric induction device 12 generates heat;
- determining measured temperature data $T_{true}(\mathbf{x}, t)$ using a measurement assembly 20, the measured temperature data $T_{true}(\mathbf{x}, t)$ comprising a temperature in each one of a plurality of different locations of the static electric induction device assembly as a function of time for a reference time range $\Delta T_{ref}$ when the static electric induction device assembly 10 is the condition in which at least a portion of the static electric induction device 12 generates heat during at least a portion of the reference time range $\Delta T_{ref}$, and
- estimating a physical quantity of a static electric induction device assembly using a method according the first aspect of the present invention.

Again with reference to Fig. 1, the enclosure 14 may have an exterior surface 22 facing away from the in the interior of the enclosure 14, wherein the measurement assembly comprises one or more sensing devices adapted to sense the temperature on a plurality of different locations on the exterior surface 22 of the enclosure 14.

As a non-limiting example, the step of determining the measured temperature data may comprises transforming images captured by the one or more thermal cameras 24 onto the exterior surface.

The method in accordance with the present invention will now be exemplified by the following time dependent partial differential equation:

$$\frac{\partial T}{\partial t} - D(T)\nabla^2 T = q_{wall}(I(t), T) - T \qquad \text{Eq. 1}$$

wherein:

T= T(x, t) represents a temperature in each one of a plurality of different locations (x) as function of time (t);
$D(T)$ represents a temperature dependent material property, such as heat conductivity, of at least a portion of the enclosure 14, and
$q_{wall}(I(t),T)$ represents enclosure wall heat losses, wherein such heat losses may be dependent on each one of the current I(t) fed to the static electric induction device 12 and the temperature T, such as the temperature of an inner side of the enclosure wall 16.

As may be realised from the above, the physical quantity forming a source term of the partial differential equation as presented in Eq. 1 above is exemplified above by the enclosure wall heat losses $q_{wall}(I(t),T)$.

Moreover, as has been indicated in the above description, the method of the present invention comprises generating a temperature model for estimated temperature data. The estimated temperature data corresponds to an estimated temperature $T_{est}(\mathbf{x}, t)$ in each one of the plurality of different locations x of the static electric induction device assembly 10 as a function of time t. The temperature model comprises a first neural network NN1 (see each one of Fig. 2 and Fig. 3) representing the estimated temperature data $T_{est}(\mathbf{x}, t)$ as well as the measured temperature data $T_{true}(\mathbf{x}, t)$.

With reference to Fig. 3, the estimated temperature data $T_{est}(\mathbf{x}, t)$ may be determined in a separate step S10 by training a first neural network NN1 using the measured temperature data $T_{true}(\mathbf{x}, t)$. As such, the result of the step S10 in Fig. 3 may be the estimated temperature data $T_{est}(\mathbf{x}, t)$.

To this end, and as indicated in Fig. 3, the step of obtaining the temperature model comprises establishing a set of temperature entities $ß_T$ associated with a probability distribution on the solution to the temperature model.

Preferably, although not necessarily, the temperature entities $ß_T$ comprise, alternatively are constituted by, temperature hyperparameters, and training the first neural network NN1 comprises generating a temperature cost function $L_{Total}$ that includes set of temperature entities $ß_T$, the estimated temperature data $T_{est}(\mathbf{x}, t)$ and the measured temperature data $T_{true}(\mathbf{x}, t)$. As a non-limiting example, the estimated temperature data $T_{est}(\mathbf{x}, t)$ and the measured temperature data $T_{true}(\mathbf{x}, t)$ may be included in an cost function $L_T(T_{est}(\mathbf{x}, t), T_{true}(\mathbf{x}, t))$ and the total cost function may be defined in accordance with the following: $L_{Total=} ß_T L_T(T_{est}(\mathbf{x}, t), T_{true}(\mathbf{x}, t))$.

Moreover, though purely by way of example, the procedure of obtaining the temperature model may comprise

- determining the set of temperature entities $ß_T$ such that a corresponding value of the temperature cost function $L_{Total}$ is within a predetermined temperature range and/or
- varying the set of temperature entities $ß_T$ until a predetermined stop condition has been obtained.

Irrespectively of how the temperature model is determined from which the estimated temperature data $T_{est}(\mathbf{x}, t)$ is determined, the thus obtained estimated temperature data $T_{est}(\mathbf{x}, t)$ may thereafter be input in Eq. 1 above in accordance with the following:

$$\frac{\partial T_{est}}{\partial t} - D(T_{est})\nabla^2 T_{est} = q_{wall}(I(t), T_{est}) - T_{est} \qquad \text{Eq. 2}$$

As may be realized from the above, using the estimated temperature data $T_{est}(\mathbf{x}, t)$ in Eq. 2 above and for instance assuming that the current $I(t)$ is known, the unknown entity in Eq. 2 above relates to the enclosure wall heat losses $q_{wall}(I(t),T)$.

The enclosure wall heat losses $q_{wall}(I(t),T)$ may be estimated by training a neural network system that uses at least the following entities: the time dependent partial differential equation (see e.g. Eq. 2), information from the temperature model (see e.g. Eq. 2) and a second neural network NN2 for the physical quantity. Purely by way of example, the above-mentioned training may be performed in a separate step S12 as indicated in Fig. 3.

As such, an estimate $q_{est}(I(t),T)$ of the enclosure wall heat losses may be determined by establishing a set of partial differential equation entities $ß_{PDE}$, $ß_{IC}$, $ß_{BC}$ associated with a probability distribution on the solution to the time dependent partial differential equation.

The method may further comprise generating a partial differential equation cost function $L_{total}$ that includes the partial differential equation entities $ß_{PDE}$, $ß_{IC}$, $ß_{BC}$ and training the neural network system may comprise:

- determining the set of partial differential equation entities $ß_{PDE}$, $ß_{IC}$, $ß_{BC}$ such that a corresponding value of the partial differential equation cost function $L_{total}$ is within a predetermined range and/or
- varying the set of partial differential equation entities $ß_{PDE}$, $ß_{IC}$, $ß_{BC}$ until a predetermined stop condition has been obtained.

Moreover, as indicated in Fig. 3 for example, the partial differential equation cost function $L_{total}$ may comprise at least one of the following:

- a set of residual entities $ß_{PDE}$ and a residual $e_{PDE}$ associated with the time dependent partial differential equation, preferably the residual entities $e_{PDE}$ comprising, alternatively being constituted by, residual functionals;
- a set of boundary condition entities $ß_{BC}$ and at least one boundary condition $L_{BC}$ associated with the time dependent partial differential equation, preferably the boundary condition entities $\beta_{BC}$ comprising, alternatively being constituted by, boundary condition functionals, and

- a set of initial condition entities $\beta_{IC}$ and at least one initial condition $L_{IC}$ associated with the time dependent partial differential equation, preferably the initial condition entities $\beta_{IC}$ comprising, alternatively being constituted by, initial condition functionals.

In the Fig. 3 example, the partial differential equation cost function $L_{total}$ includes each one of the entities listed in the above three items but it is also envisaged that other implementations of the partial differential equation cost function $L_{total}$ may include only one or two of the entities listed in the above three items.

Furthermore, in implementations of the method of the invention in which the partial differential equation cost function $L_{total}$ comprises the set of residual entities $\beta_{PDE}$, the residual $e_{PDE}$ associated with the time dependent partial differential equation may be determined using at least information from the temperature model.

To this end, although purely by way of example, the method may comprise that the neural network system tests various residual entities $\beta_{PDE}$, for instance various residual functionals. For each residual entity $\beta_{PDE}$ assessed, the residual $e_{PDE}$ may be determined using the thus assessed residual entity $\beta_{PDE}$ and the estimated temperature data $T_{est}(\mathbf{x}, t)$. Purely by way of example, the residual $e_{PDE}$ may be determined in accordance with the following:

$$e_{PDE} \sim \frac{\partial T_{est}}{\partial t} - D(T_{est})\nabla^2 T_{est} - q_{wall}(\beta_{PDE}) + T_{est} \qquad \text{Eq. 3}$$

or alternatively:

$$e_{PDE} \sim \left| \frac{\partial T_{est}}{\partial t} - D(T_{est})\nabla^2 T_{est} - q_{wall}(\beta_{PDE}) + T_{est} \right|. \qquad \text{Eq. 4}$$

By determining appropriate entities, such as appropriate residual entities $\beta_{PDE}$, it is possible to determine an estimate $q_{est}(I(t),T)$ of the enclosure wall heat losses being the physical quantity of interest in the above example.

It should be noted that although the above example uses the enclosure wall heat losses as an example, the method of the invention may also be used for other examples of the physical quantity. As non-limiting examples, the physical entity may relate to stray losses in metallic parts of the static electric induction device 12 and/or hotspot temperatures associated with the static electric induction device 12.

In such examples, the procedure presented above starting with Eq. 1 may be employed but the source term of said partial differential equation in Eq. 1 may be updated, for instance by replacing the enclosure wall heat losses $q_{wall}(I(t),T)$ source term by another source term or by adding another source term to the source term formed by the enclosure wall heat losses $q_{wall}(I(t),T)$.

Moreover, although the example presented above starting with Eq. 1 has included two separate steps S10 and S12, it is also possible that other examples of the method of the present invention may be performed in a single step.

Finally, it is to be understood that the described properties of the method for estimating a physical quantity of a static electric induction device assembly are applicable to all embodiments of such a method which fall within the ambit of the appended claims.

## Claims

1. A computer-implemented method for estimating a physical quantity of a static electric induction device assembly (10), said static electric induction device assembly (10) comprising an enclosure (14), a static electric induction device (12) and a liquid (18) whereby said enclosure (14) accommodates said static electric induction device (12) and said liquid (18) such that said static electric induction device (12) is at least partially, preferably fully, submerged into said liquid (18), said method comprising using measured temperature data obtained from a measurement assembly (20), said measured temperature data comprising a temperature ($T_{true}(\mathbf{x}, t)$) in each one of a plurality of different locations (x) of said static electric induction device assembly (10) as a function of time (t) for a reference time range ($\Delta T_{ref}$) when the static electric induction device assembly (10) is in a condition in which at least a portion of said static electric induction device (12) generates heat during at least a portion of said reference time range ($\Delta T_{ref}$),
   **characterized by** said method further comprising:

   - using a time dependent partial differential equation representing a physical condition of said static electric induction device assembly (10) during said reference time range ($\Delta T_{ref}$), wherein said physical quantity forms a source term of said partial differential equation;

- generating a temperature model for estimated temperature data, said estimated temperature data corresponding to an estimated temperature ($T_{est}(\mathbf{x}, t)$) in each one of said plurality of different locations (x) of said static electric induction device assembly (10) as a function of time (t), said temperature model comprising a first neural network (NN1) representing said estimated temperature data ($T_{est}(\mathbf{x}, t)$) as well as said measured temperature data ($T_{true}(\mathbf{x}, t)$), and

- estimating said physical quantity by training a neural network system that uses at least the following entities: said time dependent partial differential equation, information from said temperature model and a second neural network (NN2) for said physical quantity.

2. The method according to claim 1, wherein said method further comprises establishing a set of partial differential equation entities ($\beta_{PDE}$, $\beta_{IC}$, $\beta_{BC}$) associated with a probability distribution on the solution to said time dependent partial differential equation, said method further comprising generating a partial **differential** equation cost function ($L_{total}$) that includes said partial differential equation entities, wherein training said neural network system comprises:

   - determining said set of partial differential equation entities ($\beta_{PDE}$, $\beta_{IC}$, $\beta_{BC}$) such that a corresponding value of said partial differential equation cost function ($L_{total}$) is within a predetermined range and/or
   - varying said set of partial differential equation entities ($\beta_{PDE}$, $\beta_{IC}$, $\beta_{BC}$) until a predetermined stop condition has been obtained.

3. The method according to claim 2, wherein said partial differential equation cost function ($L_{total}$) comprises at least one of the following:

   - a set of residual entities ($\beta_{PDE}$) and a residual ($e_{PDE}$) associated with said time dependent partial differential equation, preferably said residual entities ($e_{PDE}$) comprising, alternatively being constituted by, residual functionals;
   - a set of boundary condition entities ($\beta_{BC}$) and at least one boundary condition ($L_{BC}$) associated with said time dependent partial differential equation, preferably said boundary condition entities ($\beta_{BC}$) comprising, alternatively being constituted by, boundary condition functionals, and
   - a set of initial condition entities ($\beta_{IC}$) and at least one initial condition ($L_{IC}$) associated with said time dependent partial differential equation, preferably said initial condition entities ($\beta_{IC}$) comprising, alternatively being constituted by, initial condition functionals.

4. The method according to claim 3, wherein said residual ($e_{PDE}$) associated with said time dependent partial differential equation is determined using at least information from said temperature model, preferably using said estimated temperature ($T_{est}(\mathbf{x}, t)$) in each one of said plurality of different locations (x) of said static electric induction device assembly (10) as a function of time (t).

5. The method according to any one of claims 2 to 4, wherein said set of partial differential equation entities comprises a set of temperature entities ($\beta_T$) associated with a probability distribution on the solution to said temperature model, wherein said partial differential equation cost function comprises an addend ($\beta_T L_T$) including said temperature entities ($\beta_T$) and a temperature cost function ($L_T$) including said estimated temperature data $T_{est}(\mathbf{x}, t)$ and said measured temperature data $T_{true}(\mathbf{x}, t)$, preferably said temperature entities ($\beta_T$) comprise, alternatively are constituted by, temperature hyperparameters.

6. The method according to any one of claim 1 to claim 4, wherein said method comprises training said first neural network (NN1) using said measured temperature data ($T_{true}(\mathbf{x}, t)$) to thereby obtain said temperature model, wherein said temperature model is thereafter used for training said neural network system.

7. The method according to claim 6, wherein the step of obtaining said temperature model comprises establishing a set of temperature entities ($\beta_T$) associated with a probability distribution on the solution to said temperature model preferably said temperature entities comprise, alternatively are constituted by, temperature hyperparameters, wherein training said first neural network comprises generating a temperature cost function ($L_{Total}$) that includes set of temperature entities ($\beta_T$), said estimated temperature data ($T_{est}(\mathbf{x}, t)$) and said measured temperature data ($T_{true}(\mathbf{x}, t)$) and

   - determining said set of temperature entities ($\beta_T$) such that a corresponding value of said temperature cost function ($L_{Total}$) is within a predetermined temperature range and/or
   - varying said set of temperature entities ($\beta_T$) until a predetermined stop condition has been obtained.

8. The method according to any one of the preceding claims, wherein said physical quantity represents at least one of the following of the static electric induction device assembly (10): heat losses through said enclosure (14), stray losses in metallic parts of the static electric induction device (12) and hotspot temperatures associated with said static electric induction device (12).

9. The method according to any one of the preceding claims, wherein said neural network system further uses a temperature dependent material property $(D(T))$, such as heat conductivity, of at least a portion of said enclosure (14).

10. A method for evaluating a static electric induction device assembly (10), said static electric induction device assembly (10) comprising a static electric induction device (12) located in the interior of an enclosure (14), said assembly further comprising a liquid (18) located in the interior of the enclosure (14), which liquid (18) surrounds said static electric induction device (12), said method comprising:

- arranging said static electric induction device assembly (10) in a condition in which at least a portion of said static electric induction device (12) generates heat;
- determining measured temperature data $(T_{true}(\mathbf{x}, t))$ using a measurement assembly (20), said measured temperature data $(T_{true}(\mathbf{x}, t))$ comprising a temperature in each one of a plurality of different locations (x) of said static electric induction device assembly (10) as a function of time (t) for a reference time range $(\Delta T_{ref})$ when said static electric induction device assembly (10) is said condition in which at least a portion of said static electric induction device (12) generates heat during at least a portion of said reference time range $(\Delta T_{ref})$, and
- estimating a physical quantity of a static electric induction device assembly (10) using a method according to any one of the preceding claims.

11. The method according to claim 10, wherein said enclosure (14) has an exterior surface (22) facing away from the in the interior of the enclosure (14), wherein said measurement assembly (20) comprises one or more sensing devices adapted to sense the temperature on a plurality of different locations on the exterior surface (22) of said enclosure (14).

12. The method according to claim 11, wherein said measurement assembly (20) comprises one or more thermal cameras (24) and wherein said step of determining measured temperature data comprises capturing images of said exterior surface (22) using said one or more thermal cameras (24), preferably said step of determining said measured temperature data comprises transforming images captured by said one or more thermal cameras onto said exterior surface (22).

13. A computer program product comprising program code for performing, when executed by a processor device, the method of any one of claims 1 - 9.

14. A non-transitory computer-readable storage medium comprising instructions, which when executed by a processor device, cause the processor device to perform the method of any one of claims 1 - 9.

15. A control unit (28) arranged to perform the method of any one of claims 1 - 9.

**Patentansprüche**

1. Computerimplementiertes Verfahren zum Schätzen einer physikalischen Größe einer statischen elektrischen Induktionsvorrichtungsanordnung (10), wobei die statische elektrische Induktionsvorrichtungsanordnung (10) ein Gehäuse (14), eine statische elektrische Induktionsvorrichtung (12) und eine Flüssigkeit (18) umfasst, wobei das Gehäuse (14) die statische elektrische Induktionsvorrichtung (12) und die Flüssigkeit (18) derart aufnimmt, dass die statische elektrische Induktionsvorrichtung (12) mindestens teilweise, vorzugsweise vollständig, in die Flüssigkeit (18) eingetaucht ist, wobei das Verfahren die Verwendung gemessener Temperaturdaten umfasst, die von einer Messanordnung (20) erhalten werden, wobei die gemessenen Temperaturdaten eine Temperatur $(T_{true}(x, t))$ an jeder einzelnen einer Vielzahl von verschiedenen Stellen (x) der statischen elektrischen Induktionsvorrichtungsanordnung (10) in Abhängigkeit von der Zeit (t) für einen Referenzzeitbereich $(\Delta T_{ref})$ umfassen, wenn sich die statische elektrische Induktionsvorrichtungsanordnung (10) in einem Zustand befindet, in dem mindestens ein Teil der statischen elektrischen Induktionsvorrichtung (12) während mindestens eines Teils des Referenzzeitbereichs $(\Delta T_{ref})$ Wärme erzeugt,
**dadurch gekennzeichnet, dass** das Verfahren ferner umfasst:

- Verwenden einer zeitabhängigen partiellen Differentialgleichung, die einen physikalischen Zustand der statischen elektrischen Induktionsvorrichtungsanordnung (10) während des Referenzzeitbereichs ($\Delta T_{ref}$) darstellt, wobei die physikalische Größe einen Quellterm der partiellen Differentialgleichung bildet;

- Erzeugen eines Temperaturmodells für geschätzte Temperaturdaten, wobei die geschätzten Temperaturdaten einer geschätzten Temperatur ($T_{est}(x, t)$) an jeder der Vielzahl von verschiedenen Stellen (x) der statischen elektrischen Induktionsvorrichtungsanordnung (10) in Abhängigkeit von der Zeit (t) entsprechen, wobei das Temperaturmodell ein erstes neuronales Netzwerk (NN1) umfasst, das die geschätzten Temperaturdaten ($T_{est}(x, t)$) sowie die gemessenen Temperaturdaten ($T_{true}(x, t)$) darstellt, und

- Schätzen der physikalischen Größe durch Trainieren eines neuronalen Netzwerksystems, das mindestens die folgenden Elemente verwendet: die zeitabhängige partielle Differentialgleichung, Informationen aus dem Temperaturmodell und ein zweites neuronales Netzwerk (NN2) für die physikalische Größe.

2. Verfahren nach Anspruch 1, wobei das Verfahren ferner das Erstellen eines Satzes von Elementen einer partiellen Differentialgleichung ($ß_{PDE}$, $ß_{IC}$, $ß_{BC}$) umfasst, die mit einer Wahrscheinlichkeitsverteilung über der Lösung der zeitabhängigen partiellen Differentialgleichung verknüpft sind, wobei das Verfahren ferner das Erzeugen einer Kostenfunktion einer partiellen Differentialgleichung ($L_{total}$) umfasst, die die betreffenden Elemente einer partiellen Differentialgleichung enthält, wobei das Training des neuronalen Netzwerksystems umfasst:

- Bestimmen des Satzes von Elementen einer partiellen Differentialgleichung ($ß_{PDE}$, $ß_{IC}$, $ß_{BC}$) derart, dass ein entsprechender Wert der Kostenfunktion einer partiellen Differentialgleichung ($L_{total}$) innerhalb eines vorbestimmten Bereichs liegt und/oder

- Variieren des Satzes von Elementen einer partiellen Differentialgleichung ($ß_{PDE}$, $ß_{IC}$, $ß_{BC}$), bis eine vorbestimmte Stoppbedingung erhalten wird.

3. Verfahren nach Anspruch 2, wobei die Kostenfunktion einer partiellen Differentialgleichung ($L_{total}$) mindestens eines der Folgenden umfasst:

- einen Satz von Residualelementen ($ß_{PDE}$) und ein Residuum ($e_{PDE}$), das mit der zeitabhängigen partiellen Differentialgleichung verknüpft ist, wobei die Residualelemente ($e_{PDE}$) vorzugsweise Residualfunktionale umfassen oder alternativ durch solche gebildet werden;

- einen Satz von Randbedingungselementen ($ß_{BC}$) und mindestens eine Randbedingung ($L_{BC}$), die mit der zeitabhängigen partiellen Differentialgleichung verknüpft ist, wobei die Randbedingungselemente ($ß_{BC}$) vorzugsweise Randbedingungsfunktionale umfassen oder alternativ durch solche gebildet werden, und

- einen Satz von Anfangsbedingungselementen ($ß_{IC}$) und mindestens eine Anfangsbedingung ($L_{IC}$), die mit der zeitabhängigen partiellen Differentialgleichung verknüpft ist, wobei die Anfangsbedingungselemente ($ß_{IC}$) vorzugsweise Anfangsbedingungsfunktionale umfassen oder alternativ durch solche gebildet werden.

4. Verfahren nach Anspruch 3, wobei das Residuum ($e_{PDE}$), das mit der zeitabhängigen partiellen Differentialgleichung verknüpft ist, unter Verwendung von mindestens Informationen aus dem Temperaturmodell bestimmt wird, vorzugsweise unter Verwendung der geschätzten Temperatur ($T_{est}(x, t)$) an jeder der Vielzahl von verschiedenen Stellen (x) der statischen elektrischen Induktionsvorrichtungsanordnung (10) in Abhängigkeit von der Zeit (t).

5. Verfahren nach einem der Ansprüche 2 bis 4, wobei der Satz von Elementen einer partiellen Differentialgleichung einen Satz von Temperaturelementen ($ß_T$) umfasst, die mit einer Wahrscheinlichkeitsverteilung über der Lösung zu dem Temperaturmodell verknüpft sind, wobei die Kostenfunktion einer partiellen Differentialgleichung einen Addenden ($ß_T L_T$), der die Temperaturelemente ($ß_T$) enthält, und eine Temperaturkostenfunktion ($L_T$), die die geschätzten Temperaturdaten $T_{est}(x, t)$ und die gemessenen Temperaturdaten $T_{true}(x, t)$ enthält, umfasst, wobei vorzugsweise die Temperaturelemente ($ß_T$) Temperaturhyperparameter umfassen oder alternativ durch solche gebildet werden.

6. Verfahren nach einem von Anspruch 1 bis Anspruch 4, wobei das Verfahren das Trainieren des ersten neuronalen Netzwerks (NN1) unter Verwendung der gemessenen Temperaturdaten ($T_{true}(x, t)$) umfasst, um dadurch das Temperaturmodell zu erhalten, wobei das Temperaturmodell danach zum Trainieren des neuronalen Netzwerksystems verwendet wird.

7. Verfahren nach Anspruch 6, wobei der Schritt des Erhaltens des Temperaturmodells das Erstellen eines Satzes von Temperaturelementen ($ß_T$) umfasst, die mit einer Wahrscheinlichkeitsverteilung über der Lösung des Temperaturmodells verknüpft sind, wobei vorzugsweise die Temperaturelemente Temperaturhyperparameter umfassen oder alternativ durch solche gebildet werden, wobei das Training des ersten neuronalen Netzwerks das Erzeugen einer Temperaturkostenfunktion ($L_{Total}$), die den Satz von Temperaturelementen ($ß_T$), die geschätzten Temperaturdaten ($T_{est}(x, t)$) und die gemessenen Temperaturdaten ($T_{true}(x, t)$) enthält, umfasst und

- Bestimmen des Satzes von Temperaturelementen ($ß_T$), so dass ein entsprechender Wert der Temperaturkostenfunktion ($L_{total}$) innerhalb eines vorbestimmten Temperaturbereichs liegt und/oder
- Variieren des Satzes von Temperaturelementen ($ß_T$), bis eine vorbestimmte Stoppbedingung erhalten wird.

8. Verfahren nach einem der vorhergehenden Ansprüche, wobei die physikalische Größe mindestens eines der folgenden der statischen elektrischen Induktionsvorrichtungsanordnung (10) darstellt: Wärmeverluste durch das Gehäuse (14), Streuverluste in metallischen Teilen der statischen elektrischen Induktionsvorrichtung (12) und Hotspot-Temperaturen, die mit der statischen elektrischen Induktionsvorrichtung (12) verknüpft sind.

9. Verfahren nach einem der vorhergehenden Ansprüche, wobei das neuronale Netzwerksystem ferner eine temperaturabhängige Materialeigenschaft (D(T)), wie z.B. die Wärmeleitfähigkeit, von mindestens einem Teil des Gehäuses (14) verwendet.

10. Verfahren zum Bewerten einer statischen elektrischen Induktionsvorrichtungsanordnung (10), wobei die statische elektrische Induktionsvorrichtungsanordnung (10) eine statische elektrische Induktionsvorrichtung (12) umfasst, die sich im Inneren eines Gehäuses (14) befindet, wobei die Anordnung ferner eine Flüssigkeit (18) umfasst, die sich im Inneren des Gehäuses (14) befindet, wobei die Flüssigkeit (18) die statische elektrische Induktionsvorrichtung (12) umgibt, wobei das Verfahren umfasst:

- Anordnen der statischen elektrischen Induktionsvorrichtungsanordnung (10) in einem Zustand, in dem mindestens ein Teil der statischen elektrischen Induktionsvorrichtung (12) Wärme erzeugt;
- Bestimmen gemessener Temperaturdaten ($T_{true}(x, t)$) unter Verwendung einer Messanordnung (20), wobei die gemessenen Temperaturdaten ($T_{true}(x, t)$) eine Temperatur an jeder einer Vielzahl verschiedener Stellen (x) der statischen elektrischen Induktionsvorrichtungsanordnung (10) in Abhängigkeit von der Zeit (t) für einen Referenzzeitbereich ($\Delta T_{ref}$) umfassen, wenn sich die statische elektrische Induktionsvorrichtungsanordnung (10) in dem Zustand befindet, in dem mindestens ein Teil der statischen elektrischen Induktionsvorrichtung (12) während mindestens eines Teils des Referenzzeitbereichs ($\Delta T_{ref}$) Wärme erzeugt, und
- Schätzen einer physikalischen Größe einer statischen elektrischen Induktionsvorrichtungsanordnung (10) unter Verwendung eines Verfahrens nach einem der vorhergehenden Ansprüche.

11. Verfahren nach Anspruch 10, wobei das Gehäuse (14) eine äußere Oberfläche (22) aufweist, die vom Inneren des Gehäuses (14) abgewandt ist, wobei die Messanordnung (20) eine oder mehrere Sensorvorrichtungen umfasst, die geeignet sind, die Temperatur an einer Vielzahl von verschiedenen Stellen auf der äußeren Oberfläche (22) des Gehäuses (14) abzufühlen.

12. Verfahren nach Anspruch 11, wobei die Messanordnung (20) eine oder mehrere Wärmebildkameras (24) umfasst und wobei der Schritt des Bestimmens von gemessenen Temperaturdaten das Aufnehmen von Bildern der äußeren Oberfläche (22) unter Verwendung der ein oder mehreren Wärmebildkameras (24) umfasst, wobei vorzugsweise der Schritt des Bestimmens der gemessenen Temperaturdaten das Umwandeln der von den ein oder mehreren Wärmebildkameras aufgenommenen Bilder auf die äußere Oberfläche (22) umfasst.

13. Computerprogrammprodukt, das Programmcode umfasst, um bei Ausführung durch eine Prozessorvorrichtung das Verfahren nach einem der Ansprüche 1 - 9 durchzuführen.

14. Nicht-transitorisches, computerlesbares Speichermedium, das Anweisungen umfasst, die bei Ausführung durch einen Prozessor den Prozessor veranlassen, das Verfahren nach einem der Ansprüche 1 - 9 durchzuführen.

15. Steuereinheit (28), die dafür ausgelegt ist, das Verfahren nach einem der Ansprüche 1 - 9 durchzuführen.

**Revendications**

1. Procédé, mis en œuvre par ordinateur, pour estimer une grandeur physique d'un ensemble de dispositif à induction électrique statique (10), ledit ensemble de dispositif à induction électrique statique (10) comprenant une enceinte (14), un dispositif (12) à induction électrique statique et un liquide (18), moyennant quoi ladite enceinte (14) reçoit ledit dispositif (12) à induction électrique statique et ledit liquide (18), de sorte que ledit dispositif (12) à induction électrique statique est au moins partiellement, de préférence totalement, immergé dans ledit liquide (18), ledit procédé comprenant d'utiliser les données de température mesurées obtenues d'un ensemble de mesure (20), lesdites données de température mesurées comprenant une température ($T_{true}(x, t)$) dans chacun d'une pluralité d'emplacements différents (x) dudit ensemble de dispositif à induction électrique statique (10) en fonction du temps (t) pour une plage de temps de référence ($\Delta T_{ref}$) lorsque l'ensemble de dispositif à induction électrique statique (10) se trouve dans un état dans lequel au moins une partie dudit dispositif à induction électrique statique (12) génère de la chaleur pendant au moins une partie de ladite plage de temps de référence ($\Delta T_{ref}$),

**caractérisé en ce que** ledit procédé comprend en outre les étapes suivantes :

- utiliser une équation aux dérivées partielles fonction du temps représentant une condition physique dudit ensemble de dispositif à induction électrique statique (10) pendant ladite plage de temps de référence ($\Delta T_{ref}$), où ladite grandeur physique forme un terme source de ladite équation aux dérivées partielles ;
- générer un modèle de température pour des données de température estimées, lesdites données de température estimées correspondant à une température estimée ($T_{est}(x, t)$) dans chacun de ladite pluralité d'emplacements différents (x) dudit ensemble de dispositif à induction électrique statique (10) en fonction du temps (t), ledit modèle de température comprenant un premier réseau neuronal (NN1) représentant lesdites données de température estimées ($T_{est}(x, t)$) ainsi que lesdites données de température mesurées ($T_{true}(x, t)$), et
- estimer ladite grandeur physique par apprentissage d'un système de réseaux neuronaux qui utilise au moins les entités suivantes : ladite équation aux dérivées partielles fonction du temps, des informations issues dudit modèle de température et un deuxième réseau neuronal (NN2) de ladite grandeur physique.

2. Procédé selon la revendication 1, dans lequel ledit procédé comprend en outre l'établissement d'un ensemble d'entités d'équation aux dérivées partielles ($\beta_{PDE}$, $\beta_{IC}$, $\beta_{BC}$) associées à une distribution de probabilité sur la solution à ladite équation aux dérivées partielles fonction du temps, ledit procédé comprenant en outre de générer une fonction de coût de l'équation aux dérivées partielles ($L_{total}$) qui inclut lesdites entités d'équation aux dérivées partielles, où l'apprentissage dudit système de réseau neuronal comprend les étapes suivantes :

- déterminer ledit jeu d'entités d'équation aux dérivées partielles ($\beta_{PDE}$, $\beta_{IC}$, $\beta_{BC}$) de sorte qu'une valeur correspondante de ladite fonction de coût de l'équation aux dérivées partielles ($L_{total}$) soit comprise dans une plage prédéterminée, et/ou
- faire varier ledit jeu d'entités d'équation aux dérivées partielles ($\beta_{PDE}$, $\beta_{IC}$, $\beta_{BC}$) jusqu'à ce qu'une condition d'arrêt prédéterminée soit obtenue.

3. Procédé selon la revendication 2, dans lequel ladite fonction de coût de l'équation aux dérivées partielles ($L_{total}$) comprend au moins l'un des éléments suivants :

- un ensemble d'entités résiduelles ($\beta_{PDE}$) et un résidu ($e_{PDE}$) associés à ladite équation aux dérivées partielles fonction du temps, de préférence lesdites entités résiduelles ($e_{PDE}$) comprenant, alternativement étant constituées par, des fonctionnels résiduels ;
- un ensemble d'entités de conditions aux limites ($\beta_{BC}$) et au moins une condition aux limites ($L_{BC}$) associées à ladite équation aux dérivées partielles fonction du temps, de préférence lesdites entités de conditions aux limites ($\beta_{BC}$) comprenant, alternativement étant constituées par, des fonctionnels de conditions aux limites, et
- un ensemble d'entités de conditions initiales ($\beta_{IC}$) et au moins une condition initiale ($L_{IC}$) associées à ladite équation aux dérivées partielles fonction du temps, de préférence lesdites entités de conditions initiales ($\beta_{IC}$) comprenant, alternativement étant constituées par, des fonctionnels de conditions initiales.

4. Procédé selon la revendication 3, dans lequel ledit résidu ($e_{PDE}$) associé à ladite équation aux dérivées partielles fonction du temps est déterminé en utilisant au moins des informations provenant dudit modèle de température, de préférence en utilisant ladite température estimée ($T_{est}(x, t)$) dans chacun de ladite pluralité de différents emplacements (x) dudit ensemble de dispositif à induction électrique statique (10) comme fonction du temps (t).

5. Procédé selon l'une quelconque des revendications 2 à 4, dans lequel ledit ensemble d'entités d'équations aux dérivées partielles comprend un ensemble d'entités de température ($\beta_T$) associées à une distribution de probabilité sur la solution dudit modèle de température, où ladite fonction de coût de l'équation aux dérivées partielles comprend un terme additionnel ($\beta_T L_T$) incluant lesdites entités de température ($\beta_T$) et une fonction de coût de température ($L_T$) incluant lesdites données de température estimée $T_{est}(x, t)$ et lesdites données de température mesurées $T_{true}(x, t)$, de préférence lesdites entités de température ($\beta_T$), alternativement sont constitués par, des hyperparamètres de température.

**6.** Procédé selon l'une quelconque des revendications 1 à 4, dans lequel ledit procédé comprend l'apprentissage dudit premier réseau neuronal (NN1) en utilisant lesdites données de température mesurées ($T_{true}(x, t)$) pour obtenir ainsi ledit modèle de température, où ledit modèle de température est ensuite utilisé pour l'apprentissage dudit système de réseau neuronal.

**7.** Procédé selon la revendication 6, dans lequel l'étape d'obtention dudit modèle de température comprend l'établissement d'un ensemble d'entités de température ($ß_T$) associées à une distribution de probabilité sur la solution dudit modèle de température, de préférence lesdites entités de température comprennent, alternativement sont constituées par, des hyperparamètres de température, où l'apprentissage dudit premier réseau neuronal comprend de générer une fonction de coût de température ($L_{Total}$) qui inclut un ensemble d'entités de température ($ß_T$), lesdites données de température estimées ($T_{est}(x, t)$) et lesdites données de température mesurées ($T_{true}(x, t)$), et

- déterminer ledit ensemble d'entités de température ($ß_T$) de sorte qu'une valeur correspondante de ladite fonction de coût de température ($L_{total}$) est comprise dans une plage de températures prédéterminée, et/ou
- faire varier ledit ensemble d'entités de température ($ß_T$) jusqu'à obtenir une condition d'arrêt prédéterminée.

**8.** Procédé selon l'une quelconque des revendications précédentes, dans lequel ladite grandeur physique représente au moins l'un des éléments suivants de l'ensemble de dispositif à induction électrique statique (10) : des pertes de chaleur à travers ladite enceinte (14), des pertes parasites dans des parties métalliques du dispositif à induction électrique statique (12) et des températures de point chaud associées audit dispositif à induction électrique statique (12).

**9.** Procédé selon l'une quelconque des revendications précédentes, dans lequel ledit système de réseau neuronal utilise en outre une propriété de matériau fonction de la température ($D(T)$), telle que la conductivité thermique, d'au moins une partie de ladite enceinte (14).

**10.** Procédé d'évaluation d'un ensemble (10) de dispositif à induction électrique statique, ledit ensemble (10) de dispositif à induction électrique statique comprenant un dispositif (12) à induction électrique statique disposé à l'intérieur d'une enceinte (14), ledit ensemble comprenant en outre un liquide (18) situé à l'intérieur de l'enceinte (14), lequel liquide (18) entoure ledit dispositif (12) à induction électrique statique, ledit procédé comprenant les étapes suivantes :

- disposer ledit ensemble de dispositif à induction électrique statique (10) dans un état dans lequel au moins une partie dudit dispositif à induction électrique statique (12) génère de la chaleur :
- déterminer des données de température mesurées ($T_{true}(x, t)$) en utilisant un ensemble de mesure (20), lesdites données de température mesurées ($T_{true}(x, t)$) comprenant une température dans chacun d'une pluralité d'emplacements différents (x) dudit ensemble de dispositif à induction électrique statique (10) en fonction du temps (t) pour une plage de temps de référence ($\Delta T_{ref}$) lorsque ledit ensemble de dispositif à induction électrique statique (10) est dans ledit état dans lequel au moins une partie dudit dispositif à induction électrique statique (12) génère de la chaleur pendant au moins une partie de ladite plage de temps de référence ($\Delta T_{ref}$), et
- estimer une grandeur physique d'un ensemble (10) de dispositif à induction électrique statique au moyen d'un procédé selon l'une quelconque des revendications précédentes.

**11.** Procédé selon la revendication 10, dans lequel ladite enceinte (14) a une surface extérieure (22) tournée à l'opposé de l'intérieur de l'enceinte (14), dans lequel ledit ensemble de mesure (20) comprend un ou plusieurs dispositifs de détection adaptés pour détecter la température sur une pluralité d'emplacements différents sur la surface extérieure (22) de ladite enceinte (14).

**12.** Procédé selon la revendication 11, dans lequel ledit ensemble de mesure (20) comprend une ou plusieurs caméras thermiques (24) et dans lequel ladite étape de détermination de données de température mesurées comprend la capture d'images de ladite surface extérieure (22) en utilisant lesdites une ou plusieurs caméras thermiques (24), de préférence ladite étape de détermination desdites données de température mesurées comprend de transformer les images capturées par lesdites une ou plusieurs caméras thermiques sur ladite surface extérieure (22).

**13.** Produit programme informatique comprenant un code de programme pour mettre en œuvre, lorsqu'il est exécuté par un dispositif de processeur, le procédé selon l'une quelconque des revendications 1 à 9.

**14.** Support de stockage non transitoire lisible par ordinateur comprenant des instructions qui, lorsqu'elles sont exécutées par un dispositif de processeur, amènent le dispositif de processeur à exécuter le procédé selon l'une quelconque des revendications 1 à 9.

**15.** Unité de commande (28) agencée pour mettre en œuvre le procédé selon l'une quelconque des revendications 1 à 9.

Fig. 1

Fig. 2

EP 4 435 397 B1

S10

$x$
$y$
$t$

$T_{est}$

$L_{total} = \beta_T L_T(T_{est}, T_{true})$

NN1

S12

$\nabla^2 T_{est}$  $\partial T_{est}/\partial t$

$x$
$y$
$l$

$q_{est}$

PDE

$e_{PDE}$

$L_{total} = \beta_{PDE} e_{PDE} + \beta_{IC} L_{IC} + \beta_{BC} L_{BC}$

NN2

$D(T)$

Fig. 3

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20160005522 A1

- US 10963540 B2